# EUROPÄISCHE PATENTSCHRIFT

(11) **EP 4 114 809 B1**
(45) Veröffentlichungstag und Bekanntmachung des Hinweises auf die Patenterteilung: **07.02.2024**
(21) Anmeldenummer: 21704202.7
(22) Anmeldetag: 24.03.2021
(51) Int. Cl.: C04B 35/645, C04B 37/02

(54) **VERFAHREN ZUR HERSTELLUNG EINES METALL-KERAMIK-SUBSTRATS**
PROCESS FOR PRODUCING A METAL-CERAMIC SUBSTRATE
PROCÉDÉ DE PRODUCTION DE SUBSTRAT MÉTAL-CÉRAMIQUE

(30) Priorität: 29.04.2020 DE 102020111698
(43) Veröffentlichungstag der Anmeldung: 11.01.2023
(73) Patentinhaber: Rogers Germany GmbH, 92676 Eschenbach (DE)
(72) Erfinder: WAGLE, Fabian, 95447 Bayreuth (DE); WELKER, Tilo, 91284 Neuhaus (DE); MEYER, Andreas, 95469 Speichersdorf (DE); SCHMIDT, Karsten, 92676 Eschenbach (DE)
(74) Vertreter: Müller Schupfner & Partner Patent- und Rechtsanwaltspartnerschaft mbB
(86) Internationale Anmeldenummer: PCT/EP2021/052470
(87) Internationale Veröffentlichungsnummer: WO 2021/219260

(56) Entgegenhaltungen:
- DE-A1-102013 113 734
- DE-B4-102013 113 734
- JP-A- S6 183 694
- JP-A- S61 222 965
- US-A- 4 611 745
- US-A1- 2010 032 143
- KATSUAKI SUGANUMA ET AL: "Effect of Interlayers in Ceramic-Metal Joints with Thermal Expansion Mismatches", JOURNAL OF THE AMERICAN CERAMIC SOCIETY,, Bd. 67, Nr. 12, 1. Dezember 1984 (1984-12-01), Seiten C-256, XP001351472,
- MORIMOTO, YUTAKA: CHEMICAL ABSTRACTS, Bd. 112:11046b, Nr. jp01141882, 1990, XP000154236, ISSN: 0009-2258

## Beschreibung

Die vorliegende Erfindung betrifft ein Verfahren zur Herstellung eines Metall-Keramik-Substrats.

Metall-Keramik-Substrate sind beispielsweise als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Voraussetzung für das Bereitstellen eines solchen Metall-Keramik-Substrats ist eine dauerhafte Anbindung der Metallschicht an die Keramikschicht. Neben einem sogenannten Direktmetallanbindungsverfahren, d. h. einem DCB- oder DAB-Verfahren, ist es aus dem Stand der Technik bekannt, die Metallschicht über ein Lotmaterial an die Keramikschicht anzubinden.

Unter einem Aktivlotverfahren, z. B. zum Verbinden von Metallschichten oder Metallfolien, insbesondere auch von Kupferschichten oder Kupferfolien, mit Keramikmaterial, ist ein Verfahren zu verstehen, welches speziell zum Herstellen von Metall-Keramik-Substraten verwendet wird. Dabei wird bei einer Temperatur zwischen ca. 650-1000°C eine Verbindung zwischen einer Metallfolie, beispielsweise einer Kupferfolie, und einem Keramiksubstrat, beispielsweise einer Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element aus der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlot-Verbindung ist.

Ferner ist, beispielsweise aus der DE 10 2013 113 734 B4 sowie aus der JP 4 - 325 470, ein Verfahren bekannt, bei dem mittels heißisostatischem Pressen eine Anbindung einer Metallschicht an eine Keramikschicht zwecks der Ausbildung eines Metall-Keramik-Substrats vollzogen wird. Das heißisostatische Pressen wird darüber hinaus auch zur Nachbehandlung verwendet, um eine Anzahl an gebildeten Lunkern, die während der Anbindung mit einem Lotverfahren oder mit einem Direktmetallanbindungsverfahren entstehen, zu reduzieren.

Ausgehend vom Stand der Technik macht es sich die vorliegende Erfindung zur Aufgabe ein Verfahren zum Herstellen von Metall-Keramik-Substraten bereitzustellen, das gegenüber den bekannten Verfahren weiter verbessert ist, insbesondere in Hinblick auf eine erfolgreiche, möglichst lunkerfreie, energiesparende und prozesssichere Anbindung des Metalls an die Keramik.

Die vorliegende Erfindung löst diese Aufgabe mit einem Verfahren zur Herstellung eines Metall-Keramik-Substrats gemäß Anspruch 1.

Weitere Ausführungsformen sind den abhängigen Ansprüchen und der Beschreibung zu entnehmen.

Gemäß einem ersten Aspekt der vorliegenden Erfindung ist ein Verfahren zur Herstellung eines Metall-Keramik-Substrats vorgesehen, umfassend:
- Bereitstellen eines Keramikelements und einer Metalllage,
- Bereitstellen eines gasdichten Behälters, der das Keramikelement umschließt,
- Ausbilden des Metall-Keramik-Substrats durch ein Anbinden der Metalllage an das Keramikelement mittels heißisostatischem Pressen,
wobei zum Ausbilden des Metall-Keramik-Substrats zwischen der Metalllage und dem Keramikelement mindestens abschnittsweise eine Aktivmetallschicht oder eine ein Aktivmetall umfassende Kontaktschicht zur Unterstützung des Anbindens der Metalllage, insbesondere des Metallbehälters, an das Keramikelement angeordnet wird.

Gegenüber den aus dem Stand der Technik bekannten Verfahren wird zum Anbinden einer Metalllage bzw. Metallschicht an das Keramikelement ein heißisostatisches Pressen genutzt, wobei zwischen der Metalllage und dem Keramikelement mindestens abschnittsweise eine Aktivmetallschicht zur Unterstützung der Anbindung der Metalllage an das Keramikelement angeordnet ist. Es hat sich dabei herausgestellt, dass durch die Nutzung einer Aktivmetallschicht die Wahrscheinlichkeit für ein erfolgreiches und prozesssicheres Anbinden sowie eine dauerhafte Anbindung der Metalllage, die beispielsweise Teil des gasdichten Metallbehälters ist, an das Keramikelement erhöht wird. Dabei ist es insbesondere vorgesehen, dass die angebundene Metallschicht bzw. Metallisierung des gefertigten Metall-Keramik-Substrats ursprünglich Teil des gasdichten Behälters ist oder eine separate Metalllage, die im Behälter, vorzugsweise in einem Glasbehälter, zusammen mit dem Keramikelement angeordnet wird. Im Rahmen des heißisostatischen Pressens wird die Metalllage dann an das Keramikelement angebunden. Der Behälter wird dabei vorzugsweise als Metallbehälter aus einer Metalllage und/oder einer weiteren Metalllage gebildet. Alternativ ist es auch vorstellbar, dass ein Glasbehälter verwendet wird.

Beim heißisostatischen Pressen ist es insbesondere vorgesehen, dass ein Erhitzen erfolgt, insbesondere ein Sintern, bei dem die Metalllage und/oder die weitere Metalllage des Metallbehälters, insbesondere die spätere Metallschicht des Metall-Keramik-Substrats, nicht in die Schmelzphase der Metalllage und/oder der weiteren Metalllage übertritt. In entsprechender Weise sind beim heißisostatischen Pressen geringere Temperaturen als bei einem Direktmetallanbindungsverfahren, insbesondere einem DCB-Verfahren, erforderlich. Im Vergleich zu der Anbindung einer Metallschicht an eine Keramikschicht mittels eines Lotmaterials, bei dem üblicherweise Temperaturen unterhalb der Schmelztemperatur der Metallschicht verwendet werden, kann bei der vorliegenden Vorgehensweise in vorteilhafter Weise auf ein Lotbasismaterial verzichtet werden und es wird lediglich ein Aktivmetall benötigt. Die Verwendung bzw. die Nutzung des Drucks beim heißisostatischem Pressen erweist sich dabei zudem als vorteilhaft, weil dadurch Lufteinschlüsse zwischen der Metalllage und/oder der weiteren Metalllage einerseits und dem Keramikelement andererseits reduziert werden können, wodurch die Ausbildung von Lunkern in ihrer Häufigkeit im gebildeten bzw. gefertigten Metall-Keramik-Substrat reduziert oder gar vermieden werden kann. Dies wirkt sich vorteilhaft auf die Qualität der Bindung zwischen der Metallschicht bzw. der Metalllage und/oder weiteren Metalllage des Metallbehälters und dem Keramikelement aus. Insbesondere wird auf diese Weise ein "solid-state diffusion bonding" (SDB)-Verfahren realisiert.

Der Fachmann versteht unter einer ein Aktivmetall umfassenden Kontaktschicht eine solche Schicht, deren Anteil an Aktivmetall größer ist als 15 Gew.-%, bevorzugt größer als 25 Gew.-% und besonders bevorzugt größer als 50 Gew.-% ist. Damit handelt es sich für den Fachmann bei der aktivmetallhaltigen Kontaktschicht nicht um ein Aktivlotmaterial, das im geringen Umfang ebenfalls Aktivmetall enthalten kann.

Vorstellbar ist auch, dass mehrere Aktivmetallschichten verwendet werden, die übereinander angeordnet werden. Außerdem ist es vorstellbar, dass auf der Metalllage und dem Keramikelement jeweils Aktivmetall und/oder eine aktivmetallhaltige Kontaktschicht aufgetragen wird. Vorzugsweise werden zwischen der Metalllage und dem Keramikelement sowohl eine Aktivmetallschicht als auch eine aktivmetallhaltige Kontaktschicht angeordnet. Bevorzugt ist die Aktivmetallschicht auf dem Keramikelement angeordnet und wird im zusammengesetzten Zustand von der Kontaktschicht bedeckt.

Außerdem können schmalere Isolationsgräben realisiert werden, beispielsweise in einer Dimension, die derjenigen Breite von Isolationsgräben entspricht, die bei mittels DCB-Verfahren hergestellten Substraten erzielt werden können. Insbesondere können Isolationsgräben um etwa 200 µm verkleinert werden, da nicht mit Lotrückständen zu rechnen ist, die bei der Nutzung von Aktivlotverfahren in der Regel bis zu etwa 200 µm in die Isolationsgräben hineinragen. Dieser Lotrückstand wird dabei ausgehend von dem Ende der Ätzflanke in Richtung des Isolationsgrabens bemessen. Die Lotrückstände bemessen sich dabei in Summe voneinander gegenüberliegenden Metallabschnitten, die einen Isolationsgraben in einer Richtung parallel zur Haupterstreckungsebene verlaufenden Richtung begrenzen.

Das Metall-Keramik-Substrat ist als Leiterplatte vorgesehen, bei der im gefertigten Zustand die Metallschicht bzw. Metallisierung, die an das Keramikelement angebunden ist, strukturiert ist. Es ist hierzu vorgesehen, dass zum Ausbilden des Metall-Keramik-Substrats neben einem heißisostatischen Pressen, auch ein Strukturieren, beispielsweise durch Laser, Ätzen und/oder eine mechanische Bearbeitung, vorgenommen wird, mit dem Leiterbahnen und/oder Anschlüsse für elektrische oder elektronische Bauteile realisiert werden. Vorzugsweise ist es vorgesehen, dass am gefertigten Metall-Keramik-Substrat an dem Keramikelement, an dem der Metallschicht gegenüberliegenden Seite, eine Rückseitenmetallisierung und/oder ein Kühlelement vorgesehen ist. Dabei dient die Rückseitenmetallisierung vorzugsweise dazu, einer Durchbiegung entgegenzuwirken und das Kühlelement dient einem wirkungsvollen Abführen von Wärme, die im Betrieb von elektrischen bzw. elektronischen Bauteilen ausgeht, die an die Leiterplatte, bzw. das Metall-Keramik-Substrat angebunden sind.

Vorzugsweise ist es vorgesehen, dass zwischen dem Metallbehälter und dem Keramikelement nur eine Aktivmetallschicht bzw. nur ein Aktivmetall vorgesehen ist. Insbesondere wird die Anbindung ohne ein Lotbasismaterial bzw. unter Verzicht auf ein Lotbasismaterial durchgeführt.

Als Aktivmetall benutzt werden Titan (Ti), Zirkonium (Zr), Hafnium (Hf), Chrom (Cr), Niob (Nb), Cer (Ce), Tantal (Ta), Magnesium (Mg), Lanthan (La) und Vanadium (V). Hierbei ist zu beachten, dass die Metalle La, Ce, Ca und Mg leicht oxidieren können. Ferner wird angemerkt, dass die Elemente Cr, Mo und W keine klassischen Aktivmetalle sind, sich aber als Kontaktschicht zwischen Si₃N₄ und der mindestens einen Metallschicht bzw. dem Lotsystem bzw. Lotmaterial eignen, da sie mit der mindestens einen Metallschicht, beispielsweise Kupfer, keine intermetallischen Phasen bilden und keine Randlöslichkeit haben. Insbesondere handelt es sich bei dem Lotbasismaterial, auf das verzichtet wird im Verfahren, um ein metallbasiertes Basismaterial, vorzugsweise um ein silberbasiertes oder ein kupferbasiertes Basismaterial. In einem silberbasierten Basismaterial ist Silber die Hauptkomponente, d. h. der Bestandteil mit dem bezüglich der Gewichtsprozente höchsten Anteil, während in einem kupferbasierten Basismaterial Kupfer die Hauptkomponente ist. Beispiele für ein silberbasiertes Basismaterial sind AgCu, insbesondere AgCu28, AgCuln, AgCuSn und AgCuGa. Beispiele für ein kupferbasiertes Basismaterial sind Kupfer CuSn, CuAg, Culn, CuGa, CuInSn, CuInMb, CuGaSn. Auch ist es vorstellbar auf ein Lotbasismaterial auf Basis von NiCrMn oder SnCu verzichten.

Weiterhin ist unter einer ein Aktivmetall umfassenden Kontaktschicht eine solche Schicht zu verstehen, die beispielsweise eine ein Aktivmetall enthaltende Verbindung umfasst, wie beispielsweise TiN, TiC oder TiO, insbesondere in unterschiedlichen Oxidationstufen bzw. in unterschiedlichen stöchiometrischen und nicht-stöchiometrischen Verbindungen. Denkbar ist auch, dass es sich um eine Legierung handelt, die ein oder mehrere Aktivmetalle aufweist.

Alternativ zum Anbinden ohne Lotbasismaterial ist es auch vorstellbar, dass zwischen der Aktivmetallschicht bzw. der Kontaktschicht und dem Metallbehälter ein Lotbasismaterial oder ein Lotmaterial, das ein Aktivmetall umfasst, angeordnet wird. Dadurch wird eine zusätzliche Bindung verursacht. Dabei ist es vorstellbar, dass die Anbindung bei einer Temperatur unterhalb oder oberhalb der Prozesstemperatur des Lotmaterials bzw. des Lotbasismaterials erfolgt. Weiterhin ist es in diesem Fall vorteilhaft, ein silberfreies Lotmaterial bzw. Lotbasismaterial zu verwenden.

Als Materialien für die mindestens eine Metallschicht und/oder die mindestens eine weitere Metallschicht im Metall-Keramik-Substrat bzw. Isolationselement sind Kupfer, Aluminium, Molybdän, Wolfram und/oder deren Legierungen wie z. B. CuZr, AlSi oder AlMgSi, sowie Laminate wie CuW, CuMo, CuAl und/oder AlCu oder MMC (metal matrix composite), wie CuW, CuMo oder AlSiC, vorstellbar. Weiterhin ist bevorzugt vorgesehen, dass die mindestens eine Metallschicht am gefertigten Metall-Keramik-Substrat, insbesondere als Bauteilmetallisierung, oberflächenmodifiziert ist. Als Oberflächenmodifikation ist beispielsweise eine Versiegelung mit einem Edelmetall, insbesondere Silber; und/oder Gold, oder (electroless) Nickel oder ENIG ("*electroless nickel immersion gold*") oder ein Kantenverguss an der Metallisierung zur Unterdrückung einer Rissbildung bzw. -weitung denkbar.

Vorzugsweise weist das Keramikelement Al₂O₃, Si₃N₄, AlN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) als Material für die Keramik auf. Es ist dabei auch vorstellbar, dass das Keramikelement als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einem Isolationselement zusammengefügt sind.

Vorzugsweise wird die Aktivmetallschicht durch ein physikalisches und/oder chemisches Gasphasenabscheiden, beispielsweise ein Sputtern, und/oder elektrochemisch oder chemisches auf das Keramikelement und/oder eine Innenseite des Metallbehälters aufgetragen. Durch die Verwendung eines Gasphasenabscheidevorgangs, beispielweise einem Sputtern, ist es in vorteilhafter Weise möglich, vergleichsweise dünne Aktivmetallschichten bereitzustellen, die insbesondere im Hinblick auf Ihre Dicke so ausgelegt werden können, dass sie sich vorteilhaft auf das Bindungsverhalten auswirken, aber beispielsweise weitere Verarbeitungsschritte wie das Ätzen einer Struktur, nicht weiter beeinträchtigen. Die Aktivmetallschicht kann dabei vor oder nach der Ausbildung des Metallbehälters auf die Metalllage und/oder die weitere Metalllage aufgetragen werden, so dass im bereitgestellten Metallbehälter an der Innenseite die Aktivmetallschicht ausgebildet ist.

Es ist vorgesehen, dass die Aktivmetallschicht strukturiert aufgetragen wird und/oder strukturiert wird. Dadurch kann gezielt bewirkt werden, dass bestimmte Bereiche frei sind von der Aktivmetallschicht, insbesondere solche Bereiche, die im gefertigten Metall-Keramik-Substrat Bereiche darstellen sollen, in denen kein Metall vorgesehen ist oder lokal keine Anbindung gewünscht ist. In diesen Bereichen werden beispielweise sogenannte Isogräben ausgebildet. Durch das gezielte Weglassen bzw. Freihalten von Aktivmetall wird der Strukturierungsvorgang, insbesondere ein "second etching", im Fertigungsprozess vereinfacht oder entfallen kann, da nicht aufwändig das Aktivmetall im Bindungsbereich zwischen der Metallschicht und dem Keramikelement wieder entfernt werden muss. Dabei ist es vorstellbar, dass zum Beispiel im Rahmen eines Gasphasenabscheidens mittels einer Maskierung dafür gesorgt wird, dass bestimmte Bereiche an der Oberseite des Keramikelemente und/oder der Innenseite des Metallbehälters freibleiben vom Aktivmetall. Alternativ ist es vorstellbar, dass vor dem Anbindungsprozess Teile der aufgetragenen Aktivmetallschicht wieder entfernt werden, beispielsweise durch Ätzen und/oder durch Laserlicht. Da in diesem Zustand noch keine Bindung zwischen dem Keramikelement und dem Aktivmetall realisiert ist, ist zu diesem Zeitpunkt ein Entfernen vergleichsweise einfach.

Zweckmäßigerweise ist es vorgesehen, dass die Aktivmetallschicht vor dem hei-βisostatischen Pressen einem Energieeintrag ausgesetzt wird. Beispielsweise ist es vorstellbar, dass mittels eines Lichtblitzes der Aktivmetallschicht Energie zugefügt wird, wie es im Rahmen eines "Flashlight-Annealing" vorgenommen wird. Dadurch wird das Bindungsverhalten des Metallbehälters über die Aktivmetallschicht an das Keramikelement weiter verbessert, bzw. es kann eine Peaktemperatur beim HIP-Prozess weiter reduziert werden, insbesondere bei niedriger schmelzenden Metallen, wie z. B. bei Aluminium und deren Legierungen. Hierbei erfolgt der Energieeintrag vorzugsweise nach dem Aufbringen der Aktivmetallschicht auf das Isolationselement oder die mindestens eine Metallschicht.

Vorzugsweise ist es vorgesehen, dass die Ausbildung des gasdichten Metallbehälters im Vakuum oder in einer definierten Gasatmosphäre durchgeführt wird, wobei insbesondere ein Innenraum des Metallbehälters vakuumiert und/oder mit Stickstoff geflutet wird.

Weiterhin ist vorstellbar, dass ein Verhältnis einer ersten Dicke der Aktivmetallschicht zu einer zweiten Dicke der Metalllage und/oder der weiteren Metalllage, aus der der Metallbehälter geformt ist bzw. wird, einen Wert annimmt, der kleiner als 0,003 bevorzugt kleiner als 0,0015, besonders bevorzugt kleiner als 0,001 ist. Weiterhin ist es bevorzugt vorgesehen, dass das Verhältnis der ersten Dicke zu der zweiten Dicke einen Wert annimmt, der größer ist als 0,00015 bevorzugt größer als 0,0002 und besonders bevorzugt größer als 0,0003. Beispielsweise nimmt das Verhältnis der ersten Dicke zur der zweiten Dicke einen Wert zwischen 0,00015 und 0,003, bevorzugt zwischen 0,0002 und 0,0015 und besonders bevorzugt zwischen 0,0003 und 0,001 an. Die vorliegenden Werte gelten insbesondere für zweite Dicken zwischen 300 µm und 1000 µm. Dadurch wird im Vergleich zur Metalllage und/oder weiteren Metalllage eine dünne Aktivmetallschicht bereitgestellt, die insbesondere nach dem Fertigungsprozess bzw. nach dem Anbinden der Metalllage und/oder der weiteren Metalllagen an das Keramikelement vergleichsweise einfach durch einen Ätzvorgang wieder entfernt werden kann.

Insbesondere für zweite Dicken, die größer sind als 1 mm, ist es vorgesehen, dass das Verhältnis der ersten Dicke der Aktivmetallschicht zu der zweiten Dicke der Metalllage und/oder der weiteren Metalllage, aus der der Metallbehälter geformt ist bzw. wird, einen Wert annimmt, der kleiner als 0,0006 bevorzugt kleiner als 0,0004, besonders bevorzugt kleiner als 0,0003 ist. Weiterhin ist es bevorzugt vorgesehen, dass das Verhältnis der ersten Dicke zu der zweiten Dicke einen Wert annimmt, der größer ist als 0,00005 bevorzugt größer als 0,00008 und besonders bevorzugt größer als 0,0001. Beispielsweise nimmt das Verhältnis der ersten Dicke zur der zweiten Dicke einen Wert zwischen 0,00005 und 0,0006, bevorzugt zwischen 0,00008 und 0,0004 und besonders bevorzugt zwischen 0,0001 und 0,0003 an.

Vorzugsweise ist es vorgesehen, dass bei einem heißisostatischem Pressen der Metallbehälter in einer Heiz- und Druckvorrichtung einem Gasdruck zwischen 100 und 2000 bar, bevorzugt 150 bar und 1200 bar und besonders bevorzugt 300 und 1000 bar und einer Prozesstemperatur von 300 °C bis zu einer Schmelztemperatur, insbesondere bis zu einer Temperatur unterhalb der Schmelztemperatur der Metalllage und/oder der weiteren Metalllage, ausgesetzt wird. Es hat sich in vorteilhafter Weise herausgestellt, dass es so möglich ist, eine Metallschicht, d.h. eine Metalllage und/oder eine weitere Metalllage des Metallbehälters, an das Keramikelement anzubinden, ohne die erforderlichen Temperaturen eines Direktmetallanbindungsverfahrens, beispielsweise eines DCB- oder einem DAB-Verfahrens, und/oder ohne ein Lotbasismaterial, das beim Aktivlöten verwendet wird zu erreichen. Darüber hinaus gestattet das Nutzen bzw. die Verwendung eines entsprechenden Gasdrucks die Möglichkeit, möglichst lunkerfrei, d. h. ohne Gaseinschlüsse zwischen Metallschicht und Keramikelement ein Metall-Keramik-Substrat zu fertigen. Insbesondere finden Prozessparameter Verwendung, die in der DE 10 2013 113 734 A1 erwähnt werden und auf die hiermit explizit Bezug genommen wird.

Weiterhin ist es bevorzugt vorgesehen, dass zur Ausbildung eines Metallbehälters eine Metalllage und eine weitere Metalllage vorgesehen sind, die derart dimensioniert sind, dass jeweils ein Abschnitt der Metalllage und der weiteren Metalllage gegenüber einem äußersten Rand des Keramikelements überstehen, wobei die überstehenden Abschnitte zur Ausbildung des Metallbehälters verbunden werden, vorzugsweise nachdem sie mit einer Spannkraft verformt wurden. Es hat sich herausgestellt, dass auf diese Weise ein gasdichter Metallbehälter gefertigt werden kann, wobei die überstehenden Abschnitte der Metalllage und der weiteren Metalllage nach dem Verbinden einen verbunden Bereich ausbilden, der das Keramikelement in einer parallel zur Haupterstreckungsebene verlaufenden Ebene umlaufend bzw. rahmenartig umgibt. Insbesondere ist es dabei vorgesehen, dass zur Ausbildung des Metallbehälters die freien Randabschnitte der Metalllage und der weiteren Metalllage vor deren direkten Verbindung durch Beaufschlagen mit einer Spannkraft verformt und anschließend die freien Randabschnitte der Metallschicht randseitig durch Schweißen, insbesondere Kontaktschweißen oder Laserschwei-ßen oder durch Löten, auch Hartlöten, miteinander verbunden werden. Alternativ oder ergänzend kann die randseitige direkte Verbindung der Metalllage und weiteren Metalllage mittels eines mechanischen Verbindens oder eines Bearbeitungsverfahrens hergestellt werden, wie beispielsweise einem Walzen, Verpressen und/oder Umbördeln der freien Randabschnitte. Zur Ausbildung des Metallbehälters verweist die Anmeldung ausdrücklich auf den Offenbarungsgehalt der Anmeldung DE 102013 113 734 A1.

Weiterhin ist es bevorzugt vorgesehen, dass die Aktivmetallschicht als Folie bereitgestellt wird. Beispielsweise ist es vorstellbar, dass die Aktivmetallschicht zusammen mit der Metalllage und/oder der weiteren Metalllage, aus der der Metallbehälter geformt wird, bereitgestellt wird. Beispielsweise werden beide, d. h. die Metalllage und/oder die weitere Metalllage und die Aktivmetallschicht gemeinsam bereitgestellt und vorzugsweise mittels Walzen auf eine bevorzugte Dicke heruntergewalzt. Alternativ ist es vorstellbar, dass die Aktivmetallschicht separat als einzelne Folie auf das Keramikelement oder zwischen das Keramikelement und den Metallbehälter angeordnet wird. Die Verwendung einer Folie erweist sich insbesondere deshalb als vorteilhaft, weil eine möglichst homogene und gleichbleibende Dicke der Aktivmetallschicht bereitgestellt werden kann. Außerdem lassen sich vergleichsweise dünne Aktivmetallschichten hierdurch realisieren. Weiterhin ist es vorstellbar, dass die Aktivmetallschicht auf der mindestens einen Metallschicht aufgetragen wird.

Vorzugsweise ist es vorgesehen, dass die Metalllage Teil des Behälters ist oder den Behälter zumindest teilweise formt. In diesem Fall wird die Metalllage und/oder die weitere Metalllage Teil des späteren Metall-Keramik-Substrats. Vorzugsweise liegt der gasdichte Behälter, insbesondere der Glasbehälter, mit seiner Innenseite an der Metalllage und/oder weiteren Metalllage an während des hei-βisostatischen Pressens, um gleichmäßig die Metalllage und/oder die weitere Metalllage an das Keramikelement anzupressen, wobei die Wirkung des Anpressens vom Behälter auf das Ensemble übertragen wird. Hierzu herrscht außerhalb des Behälters ein entsprechender Druck, der die anpressende Wirkung auf das Ensemble veranlasst.

Insbesondere wird durch das vorgeschlagene Verfahren ein Metall-Keramik-Substrat bereitgestellt, bei dem aufgrund der herrschenden Druckverhältnisse nahezu keine Lunker mehr auftreten bzw. die Anzahl der Lunker reduziert ist gegenüber den Metall-Keramik-Substraten, die mit einem AMB- oder DCB-Verfahren hergestellt werden. Außerdem bildet sich eine im Profil konstante Metallschichtdicke aus, die dem Profilverlauf der Keramikoberfläche folgt. Weiterhin gestattet das Verfahren auf silberhaltige Lotbasismaterialien zu verzichten, was das second etching vereinfacht. Infolgedessen können schmalere Isolationsgräben realisiert werden, beispielsweise in einer Dimension, die derjenigen Breite von Isolationsgräben entspricht, die bei mittels DCB-Verfahren hergestellten Substraten erzielt werden können. Insbesondere können Isolationsgräben um etwa 200 µm verkleinert werden, da nicht mit Lotrückständen zu rechnen ist, die in der Regel bis zu 100 µm pro Seite in die Isolationsgräben hineinragen. Dieser Lotrückstand wird dabei ausgehend von dem Ende der Ätzflanke in Richtung des Isolationsgrabens bemessen. Die Lotrückstände bemessen sich dabei in Summe von einander gegenüberliegenden Metallabschnitten, die einen Isolationsgraben in einer Richtung parallel zur Haupterstreckungsebene verlaufenden Richtung begrenzen. Außerdem kann eine Fransenbildung an dem Grenzverlauf zwischen der Metallschicht und dem Keramikelement reduziert werden, da die Silberanteile im Lotmaterial andernfalls zu einem schwer kontrollierbaren Ätzen führen, was sich augenscheinlich in fransenähnlichen Verläufen äußert in einer parallel zur Haupterstreckungsebene verlaufenden Richtung. Außerdem gestattet es die konstante Dicke der Metallschicht, die sich über das gesamte Metall-Keramik-Substrat nicht ändert, das Ätzverfahren für alle Bereich des Metall-Keramik-Substrat in gleicher Weise durchzuführen, ohne Modulationen in der Dicke der Metallschicht mitberücksichtigen zu müssen. Die konstante Dicke stellt sich dadurch ein, dass der beim heißisostatischen Pressen verwendete Druck die Metalllage bzw. Metallschicht homogen an den Profilverlauf des Keramikelements anpresst. Außerdem ist es in vorteilhafter Weise daher möglich, durch die homogene Materialverteilung in der Metallschicht eine über das Metall-Keramik-Substrat gesehen gleichmäßige bzw. einheitliche Ätzflankengeometrie einzustellen.

Insbesondere ist es vorgesehen, dass sich die mindestens eine Metallschicht und das Isolationselement entlang einer Haupterstreckungsebene erstrecken und entlang einer senkrecht zur Haupterstreckungsebene verlaufenden Stapelrichtung übereinander angeordnet sind, wobei im gefertigten Trägersubstrat eine Bindungsschicht zwischen der mindestens einen Metallschicht und dem Isolationselement ausgebildet ist, wobei eine Haftvermittlerschicht der Bindungsschicht einen Flächenwiderstand aufweist, der größer als 5 Ohm/sq, bevorzugt größer als 10 Ohm/sq und besonders bevorzugt größer als 20 Ohm/sq ist.

Gegenüber den aus dem Stand der Technik bekannten Trägersubstraten ist es erfindungsgemäß vorgesehen, dass der Flächenwiderstand einer Haftvermittlerschicht der Bindungsschicht größer ist als 5 Ohm/sq, bevorzugt größer als 10 Ohm/sq und besonders bevorzugt größer als 20 Ohm/sq. Der ermittelte Flächenwiderstand steht dabei im direkten Zusammenhang mit einem Anteil des Aktivmetalls in der Haftvermittlerschicht, die maßgeblich für die Anbindung der mindestens einen Metallschicht an das Isolationselement ist. Dabei nimmt der Flächenwiderstand mit abnehmenden Aktivmetallanteil in der Bindungsschicht zu. Ein entsprechend hoher Flächenwiderstand entspricht somit einem geringen Aktivmetallanteil in der Haftvermittlerschicht. Es hat sich dabei herausgestellt, dass mit zunehmenden Anteil an Aktivmetall, die Bildung von spröden intermetallischen Phasen begünstigt wird, was wiederum nachteilig ist für eine Abzugsfestigkeit der Metallschicht an die Isolationsschicht. Mit anderen Worten: Mit den anspruchsgemäßen Flächenwiderständen werden solche Bindungsschichten bereitgestellt, deren Abzugsfestigkeit aufgrund der reduzierten Bildung von spröden intermetallischen Phasen, verbessert, d. h. vergrößert wird. Durch das gezielte Einstellen der anspruchsgemäßen Flächenwiderstände lassen sich somit besonders starke Anbindungen der mindestens einen Metallschicht an das Keramikelement realisieren.

Dabei ist es zur Bestimmung des Flächenwiderstands vorgesehen, dass am gefertigten Trägersubstrat zunächst die Metallschicht und ggf. eine Lotbasisschicht, beispielsweise durch Ätzen, wieder entfernt werden. Mittels einer Vier-Punkt Messung wird dann an der Oberseite bzw. Unterseite des von der mindestens einen Metallschicht und der Lotbasisschicht befreiten Trägersubstrats ein Flächenwiderstand gemessen. Insbesondere ist unter dem Flächenwiderstand einer Materialprobe dessen Widerstand bezogen auf einen quadratischen Oberflächenbereich zu verstehen. Es ist hierbei üblich den Oberflächenwiderstand mit der Einheit Ohm/sq zu kennzeichnen. Die Physikalische Einheit des Flächenwiderstandes ist Ohm.

Vorzugsweise ist es vorgesehen, dass eine in Stapelrichtung bemessene Dicke der Bindungsschicht, gemittelt über mehrere Messpunkte innerhalb einer vorbestimmten Fläche oder in mehreren Flächen, die parallel zur Haupterstreckungsebene verläuft oder verlaufen, einen Wert annimmt, der kleiner als 20 µm, bevorzugt kleiner als 10 µm und besonders bevorzugt kleiner als 6 µm ist. Sofern vom mehreren Flächen gesprochen wird, ist insbesondere gemeint, dass die mindestens eine Metallschicht in möglichst gleich große Flächen unterteilt wird und in jeder dieser die mindestens eine Metallschicht unterteilenden Flächen mindestens ein Wert, bevorzugt mehrere Messwerte für die Dicke erfasst werden. Die so an verschiedenen Stellen ermittelten Dicken werden arithmetisch gemittelt.

Gegenüber den aus dem Stand der Technik bekannten Trägersubstraten ist somit eine vergleichsweise dünne Bindungsschicht zwischen der mindestens einen Metallschicht und dem Isolationselement ausgebildet. Dabei ist es vorgesehen, dass zur Festlegung der maßgeblichen Dicken der Bindungsschicht die gemessenen Dicken über eine Vielzahl von Messpunkten gemittelt werden, die innerhalb einer vorbestimmten bzw. festgelegten Fläche liegen. Dadurch wird in vorteilhafter Weise mitberücksichtigt, dass das Isolationselement, insbesondere das Keramikelement, in der Regel einer Ondulation unterworfen ist, d. h. dem Isolationselement ist eine Welligkeit zuzusprechen. Insbesondere versteht der Fachmann unter einer Welligkeit eine Modulation des generellen flachen Verlaufs des Isolationselements, gesehen über mehrere Millimeter oder Zentimeter entlang einer Richtung, die parallel zur Haupterstreckungsebene verläuft. Damit grenzt sich eine derartige Ondulation von einer Oberflächenrauigkeit des Isolationselements ab, die in der Regel zusätzlich am Isolationselement vorliegt. Durch das Einbeziehen einer derartigen, in der Regel unvermeidbaren Ondulation des Isolationselements in die Bestimmung der Dicke wird berücksichtigt, dass die Bindungsschicht aufgrund der Ondulation gegebenenfalls variieren kann, insbesondere in Talbereichen des Isolationselements größer sein kann als in Bergbereichen des Isolationselements.

Ungeachtet dieser Ondulation ist der gemittelte Dickenwert dennoch deutlich geringer als derjenige, der in Trägersubstraten aus dem Stand der Technik bekannt ist. Dies wird insbesondere bzw. beispielsweise dadurch erzielt, dass eine benötigte Aktivmetallschicht zwischen dem Isolationselement und der mindestens einen Metallschicht angeordnet wird, die insbesondere einzeln, also separat angeordnet ist, beispielsweise zusätzlich zu einem Lotbasismaterial. Vorzugsweise wird das Aktivmetall mittels eines chemischen und/oder physikalischen Gasphasenabscheidens, beispielsweise mittels eines Sputterns, auf dem Lotbasismaterial und/oder der mindestens einen Metallschicht und/oder dem Isolationselement aufgetragen, um vergleichsweise dünne Aktivmetallschichten zu realisieren, die wiederrum zu einer vergleichsweise dünnen Bindungsschicht führen, insbesondere zu einer homogenen und dünnen Haftvermittlerschicht. Vorstellbar ist es auch unter Verwendung eines Plasmas, in einem Vakuum und/oder mittels Aufdampfen die Aktivmetallschicht auf dem Lotbasismaterial, dem Isolationselement und/oder der mindestens einen Metallschicht bereitzustellen. Denkbar ist auch, die Aktivmetallschicht galvanisch zu realisieren. Besonders bevorzugt ist es vorgesehen, dass die Aktivmetallschicht als Folie bereitgestellt wird.

Die Ausbildung von vergleichsweise dünnen Bindungsschichten reduziert insbesondere einen Aufwand, der aufgebracht werden muss, um beispielsweise in einem "second etching", zumindest bereichsweise, die Bindungsschicht wieder zu entfernen, um das Trägersubstrat, dessen mindestens eine Metallschicht und die Bindungsschicht, zu strukturieren. Vorzugsweise erfolgt dieses Strukturieren, das dazu dient, mehrere Metallabschnitte der mindestens einen Metallschicht voneinander elektrisch zu isolieren, durch ein Ätzen und/oder ein mechanischen Bearbeitungsschritt und/oder mit Laserlicht. Außerdem hat es sich als vorteilhaft erwiesen, dass durch die Verwendung geringer Schichtdicken die Anzahl der möglichen Fehler in der Bindungsschicht, beispielsweise hervorgerufen durch Materialfehler im Lotmaterial, in vorteilhafter Weise reduziert werden kann. Unter einem Fehler in der Bindungsschicht bzw. einem Materialfehler im Lotmaterial wird beispielsweise ein großes Korn im Lotmaterial, wie beispielswiese ein Aktivmetallkorn, verstanden, das zur Riesenbildung einer Körnung in der Bindungsschicht führen kann, und/oder das nicht vollständig aufschmilzt und damit als Abstandshalter minimale Lotspalte verhindert. Durch das Auftragen, insbesondere mittels Sputtern, kann in einfacher Weise verhindert werden, dass vergleichsweise große Körner Bestandteil der Aktivmetallschicht und insbesondere der späteren Bindungsschicht werden. Schließlich ist es von Vorteil, dass sich homogen über das hergestellte Trägersubstrat eine dünne Bindungsschicht ausbildet.

Besonders bevorzugt ist folgendes Verfahren zur Bestimmung und Auswahl der zur Bestimmung beitragenden Messbereiche - unabhängig von der Größe des Trägersubstrats - vorgesehen:
In einem ersten Schritt wird die mindestens eine Metallschicht des Trägersubstrats in neun gleich große Rechtecke, insbesondere Quadrate, d. h. in mehrere Flächen, unterteilt. In den so festgelegten Messbereichen werden jeweils zwei oder drei Schnittbilder erzeugt, die herangezogen werden, um in jedem der Schnittbilder eine gemittelte Dicke für die mindestens eine Metallschicht zu bestimmen. Die Schnittbilder werden bevorzugt mittels eines REM-Verfahrens aufgenommen, beispielsweise in einer 2000 oder 2500- fachen Vergrößerung. Anschließend wird in einem zweiten Schritt über die insgesamt 18 oder 27 in den Schnittbildern erfassten gemittelten Dicken, die über alle neun rechteckigen Messbereiche verteilt sind, gemittelt. Auf diese Weise wird in vorteilhafter Weise sichergestellt, dass die gemittelte Dicke einen repräsentativen Wert für die Bindungsschicht zwischen der mindestens einen Metallschicht und dem Isolationselement darstellt. Mit anderen Worten: die in dem Abschnitt beschriebene Vorgehensweise sieht gemittelte Dicken vor, die über die mindestens eine Metallschicht gesehen in gleichmäßig verteilten Messbereichen bestimmt ist. Das hier beschriebene Verfahren zur Auswahl der Messbereiche, die zur Bestimmung eines gemittelten Werts für die Dicke beiträgt ist analog für die Bestimmung des Flächenwiderstands heranzuziehen.

Vorzugsweise ist es vorgesehen, dass die Bindungsschicht und/oder die weitere Bindungsschicht eine ein Aktivmetall umfassende Haftvermittlerschicht ist. Insbesondere ist es vorgesehen, dass die Bindungsschicht nur aus der Haftvermittlerschicht ausgebildet ist, die das Aktivmetall umfasst. Dabei weist die Haftvermittlerschicht in der Bindungsschicht eine Verbindung mit einem Bestandteil des Keramikelements, wie beispielsweise Stickstoff, Sauerstoff oder Kohlenstoff, und den anderen Bestandteilen der Keramik auf. In entsprechender Weise umfasst die Haftvermittlerschicht beispielsweise Titannitrid, Titanoxid und/oder Titancarbid. In diesem Fall ist es vorgesehen, dass eine in Stapelrichtung gemessene Dicke der Bindungsschicht gemittelt über mehrere Messpunkte innerhalb einer Fläche, die parallel zur Haupterstreckungsebene verläuft, oder der mehreren Flächen einen Wert annimmt der kleiner ist als 0,003 mm, bevorzugt kleiner als 0,001 mm und besonders bevorzugt kleiner als 0,0005 oder sogar kleiner als 0,00035 mm. Insbesondere für solche Bindungsschichten, bei den auf ein Lotbasismaterial und/oder einen Silberanteil verzichtet wird, lässt sich in entsprechender Weise eine noch dünnere Bindungsschicht ausbilden.

Weitere Vorteile und Eigenschaften ergeben sich aus der nachfolgenden Beschreibung bevorzugter Ausführungsformen des erfindungsgemäßen Gegenstands mit Bezug auf die beigefügten Figuren. Es zeigt:

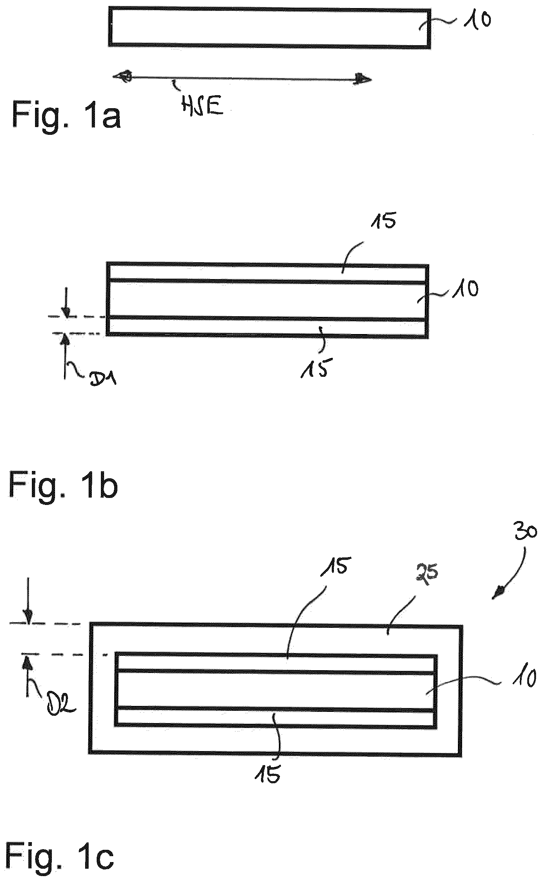

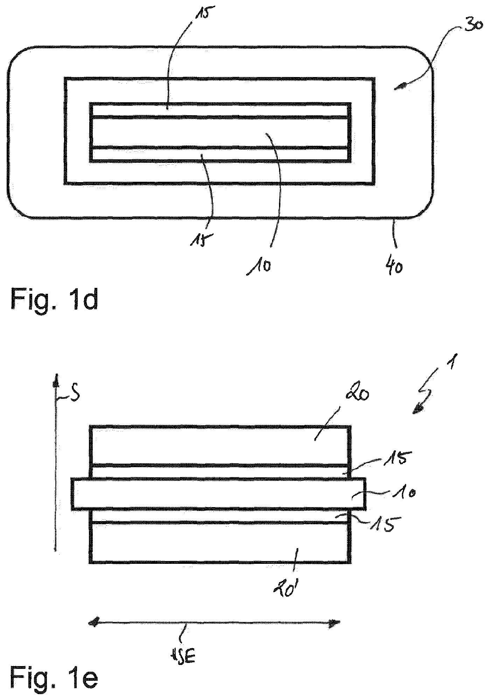

- **Fig. 1a bis 1e:**: Verfahren zur Herstellung eines Metall-Keramik-Substrats gemäß einer ersten beispielhaften Ausführungsform der vorliegende Erfindung.

In den **Figuren 1a bis 1e** ist ein Verfahren zur Herstellung eines Metall-Keramik-Substrats 1 gemäß einer ersten beispielhaften Ausführungsform der vorliegenden Erfindung dargestellt. Solche Metall-Keramik-Substrate 1 dienen vorzugsweise als Träger bzw. Leiterplatte für elektronische bzw. elektrische Bauteile, die an eine Metallschicht 20 des Metall-Keramik-Substrats 1 anbindbar sind. Dabei ist es vorgesehen, dass die Metallschicht 20 strukturiert ist, um entsprechende Leiterbahnen und/oder Anschlussflächen auszubilden. Die sich im Wesentlich entlang einer Haupterstreckungsebene HSE erstreckende Metallschicht 20 und das Keramikelement 10 sind dabei entlang einer senkrecht zur Haupterstreckungsebene HSE verlaufenden Stapelrichtung S übereinander angeordnet und vorzugsweise miteinander gefügt bzw. verbunden. Vorzugsweise umfasst das Metall-Keramik-Substrat 1 neben der Metallschicht 20 eine Rückseitenmetallisierung 20', die in Stapelrichtung S gesehen an der der Metallschicht 20 gegenüberliegenden Seite des Keramikelements 10 angeordnet und angebunden ist. Die Rückseitenmetallisierung 20' und/oder ein beispielsweise zusätzliches Kühlelement dienen insbesondere dazu, einem Durchbiegen des Metall-Keramik-Substrats 1 entgegenzuwirken und/oder dazu, einen Wärmeeintrag, hervorgerufen durch elektrische oder elektronische Bauteile auf dem Metall-Keramik-Substrat 1, abzuführen.

Das in den Figuren 1a bis 1e beschriebene Verfahren dient insbesondere der Anbindung der Metallschicht 20 und/oder der Rückseitenmetallisierung 20' an das Keramikelement 10. Hierzu wird zunächst ein Keramikelement 10 bereitgestellt (siehe Figur 1a). In den Figuren 1b und 1c wird ein Ensemble 30 geformt, wobei das Ensemble 30 neben dem Keramikelement 10 eine Aktivmetallschicht 15 und einen Metallbehälter 25 umfasst. In dem dargestellten Ausführungsbeispiel wird zunächst die Aktivmetallschicht 15, vorzugsweise beidseitig, auf dem Keramikelement 10 angeordnet. Dies kann beispielsweise mittels eines physikalischen und/oder chemischen Gasphasenabscheidevorgangs und/oder elektrochemisch erfolgen. Alternativ könnte die Aktivmetallschicht 15 auch an einer Innenseite des Metallbehälters 25 ausgebildet werden. Die Innenseite des Metallbehälters 25 ist dabei im Ensemble 30 dem Keramikelement 10 zugewandt.

In dem in Figur 1c dargestellten Ensemble 30 umschließt der Metallbehälter 25 das Keramikelement 10 und die Aktivmetallschicht 15 vollständig. Hierbei betrifft das Umschließend die Teile der Aktivmetallschicht 15, der innerhalb des Metallbehälters 25 angeordnet ist (beispielsweise könnte sich die Aktivmetallschicht 15 über den Rand des Keramikelements 10 erstreckend und zwischen den zu fügenden Enden der Metalllage angeordnet sein). Dabei ist in Stapelrichtung S gesehen die Aktivmetallschicht 15 zwischen einer Innenseite des Metallbehälters 25 und dem Keramikelement 10 angeordnet. Insbesondere handelt es sich bei dem Metallbehälter 25 um einen gasdichten Metallbehälter 25, der insbesondere flächig, insbesondere vollflächig mit seiner Innenseite an der Aktivmetallschicht 15 und/ oder dem Keramikelement 10 anliegt.

Beispielsweise lässt sich ein derartiger Metallbehälter 25 mittels einer Metalllage und einer weiteren Metalllage herstellen, indem zwischen der Metalllage und der weiteren Metalllage ein Subensemble aus Keramikelement 10 und vorzugsweise den beidseitig am Keramikelement 10 angeordneten Aktivmetallschichten 15 anordnet wird. Dabei sind die Metalllage und die weitere Metalllage vorzugsweise derart dimensioniert, dass sie in Richtung der Haupterstreckungsebene HSE gegenüber einem äußersten Rand des Keramikelements 10 und/oder der Aktivmetallschicht 15 überstehen. Alternativ ist es auch vorstellbar, dass der Metallbehälter 25 durch ein Anbinden der Metalllage und/oder der weiteren Metalllage an das Keramikelement 10, beispielsweise durch ein Hartlöten erfolgt. In diesem Fall muss die Metalllage und/oder weitere Metalllage nicht gegenüber dem Keramikelement 10 überstehen. Die jeweils überstehenden Abschnitte derMetalllage und weiteren Metalllage können dann anschließend, vorzugsweise entlang eines Umfangs des Subensembles aus Keramikelement 10 und Aktivmetallschicht 15, miteinander verbunden werden, sodass ein gasdichter Metallbehälter 25 ausgebildet wird. Vorzugsweise erfolgt das Ausbilden des Metallbehälters 25 unter Vakuum. Es ist auch vorstellbar, dass aus der Metalllage ein Beutel gebildet wird, in dem das Keramikelement 10 und die Aktivmetallschicht 15 angeordnet werden. Anschließend wird der Beutel gasdicht verschlossen.

Weiterhin ist bevorzugt vorgesehen, dass die Aktivmetallschicht 15 in einer parallel zur Stapelrichtung S verlaufenden Richtung eine erste Dicke D1 und die Metalllage und/oder weitere Metalllage, aus der der Metallbehälter 25 gebildet wird, eine in dieselbe Richtung bemessene zweite Dicke D2 aufweist, insbesondere im Bereich einer Ober und/oder Unterseite des Subensembles. Dabei ist es vorgesehen, dass ein Verhältnis der ersten Dicke D1 zur zweiten Dicke D2 kleiner als 0,0006 bevorzugt kleiner als 0,0004, besonders bevorzugt kleiner als 0,0003 ist. Mit anderen Worten: Die Aktivmetallschicht 15 ist vergleichsweise dünn im Vergleich zu der zweiten Dicke D2 der Metalllage und/oder der weiteren Metalllage, die zur Ausbildung des Metallbehälters 25 verwendet wird.

Weiterhin ist es vorgesehen, dass das Ensemble 30, das den Metallbehälter 25, das Keramikelement 10 und die zwischen den Metallbehälter 25 und dem Keramikelement 10 in Stapelrichtung S gesehen angeordnete Aktivmetallschicht 15 umfasst, einer Heiz- und Druckvorrichtung 40 zugeführt wird (Figur 1d). In der Heiz- und Druckvorrichtung 40 erfolgt das zumindest abschnittsweise Anbinden des Metallbehälters 25 an das Keramikelement 10 mittels heißisostatischem Pressen, indem das Ensemble 30 einem Gasdruck zwischen 100 bar und 2000 bar, bevorzugt 150 bar und 1200 bar und besonders bevorzugt 300 und 1000 bar und einer Prozesstemperatur zwischen 300 °C bis zu einer Temperatur unterhalb einer Schmelztemperatur der Metalllage, beziehungsweise bis zu einer Schmelztemperatur ausgesetzt wird. Insbesondere ist es beim heißisosatischen Pressen vorgesehen, dass ein Sintern rfolgt, d.h. es erfolgt ein Erhitzen, ohne die Ausbildung einer Schmelze, über die im Rahmen eines DCB-Verfahrens typischerweise die Anbindung einer Metallschicht an das Keramikelement erfolgt. Damit ist es möglich, eine Anbindung zwischen der Metalllage des Metallbehälters 25 und dem Keramikelement 10 zu schaffen, ohne die erforderlicheren Temperaturen eines DCB-Verfahrens aufbringen zu müssen. Gleichzeitig reduziert der Gasdruck beim hei-βisostatischen Pressen die Anzahl, bzw. Häufigkeiten von Lunkern, d. h. Gaseinschlüssen zwischen der Metalllage und/oder weiteren Metalllage und dem Keramikelement 10. Dadurch wird eine verbesserte Anbindung und eine qualitativ hochwertigere Verbindung zwischen dem Keramikelement 10 und der Metallschicht 20 ermöglicht.

Dabei hat es sich herausgestellt, dass sich die Verwendung einer Aktivmetallschicht 15 positiv auf den Anbindungsprozess und die Anbindung der Metalllage und/oder der weiteren Metalllage des Metallbehälters 25 an das Keramikelement 10 auswirkt. Insbesondere unterscheidet sich das heißisostatische Pressen unter Verwendung einer Aktivmetallschicht 15 von einem Lotprozess dadurch, dass beim Lotprozess neben dem Aktivmetall typischerweise ein Lotbasismaterial erforderlich ist, um die Anbindung zwischen Metallschicht 20 und dem Keramikelement 10 zu gewährleisten. Im Anschluss an das Anbinden der Metallschicht 20 beziehungsweise der Metalllage und/oder weiteren Metalllage des Metallbehälters 25 an das Keramikelement 10 ist es vorgesehen, dass das Ensemble 30 befreit wird von Teilen bzw. Abschnitten des gasdichten Metallbehälter 25, insbesondere indem Teile der Metalllage und/oder weiteren Metalllagen, die den Metallbehälter 25 bilden, wieder entfernt werden.

Es erfolgt gleichzeitig eine Strukturierung der Metalllage und/oder weiteren Metalllage, bzw. der Metallschicht 20, die im Rahmen des heißisostatischem Pressens an das Keramikelement 10 angebunden wurde. Insbesondere werden die Abschnitte entfernt, die zur Ausbildung des Metallbehälters 25 gegenüber dem Keramikelement 10 und/oder der Aktivmetallschicht 15 in Richtung der Haupterstreckungsebene HSE überstanden und miteinander zur Ausbildung des gasdichten Metallbehälters 25 verbunden wurden (siehe Figur 1c). Mit anderen Worten: Vorzugsweise wird ein das Keramikelement 10 umlaufender und rahmenartiger Abschnitt des Metallbehälters 25 entfernt.

Weiterhin ist es vorgesehen, dass die Metalllage und/oder weitere Metalllage bzw. die Metallschicht 20, d. h. die Metallisierung, des gefertigten Metallsubstrats 1 derart strukturiert ist bzw. strukturiert wird, dass das Keramikelement 10 gegenüber dem äußersten Rand der Metallschicht 20 in Richtung einer parallel zur Haupterstreckungsebene HSE verlaufenden Richtung übersteht. Auf diese Weise wird ein sogenannter Pullback erzeugt, der zur elektrischen Isolation zwischen Metallschicht 20 und Rückseitenmetallisierung 20' beiträgt und Überschläge verhindert.

### Bezugszeichenliste:

- 1: Metall-Keramik-Substrat
- 10: Keramikelement
- 15: Aktivmetallschicht
- 20: Metallschicht
- 20': Rückseitenmetallisierung
- 25: Metallbehälter
- 30: Ensemble
- 40: Heiz- und Druckvorrichtung
- S: Stapelrichtung
- D1: erste Dicke
- D2: zweite Dicke
- HSE: Haupterstreckungsebene

## Patentansprüche

1. Verfahren zur Herstellung eines Metall-Keramik-Substrats (1), umfassend:
- Bereitstellen eines Keramikelements (10) und einer Metalllage,
- Bereitstellen eines gasdichten Behälters (25), der das Keramikelement (10) umschließt, wobei der Behälter (25) vorzugsweise aus der Metalllage geformt ist oder die Metalllage umfasst,
- Ausbilden des Metall-Keramik-Substrats (1) durch ein Anbinden der Metalllage an das Keramikelement (10) mittels heißisostatischem Pressen,
wobei zum Ausbilden des Metall-Keramik-Substrats (1) zwischen der Metalllage und dem Keramikelement (10) mindestens abschnittsweise eine Aktivmetallschicht (15) oder eine ein Aktivmetall umfassende Kontaktschicht, zur Unterstützung des Anbindens der Metalllage an das Keramikelement (10), angeordnet wird, wobei das Aktivmetall Titan, Zirkonium, Hafnium, Chrom, Niob, Cer, Tantal, Magnesium, Lanthan, Vanadium, Molybdän oder Wolfram ist, wobei ein Anteil an Aktivmetall in der Kontaktschicht größer ist als 15 Gew.-% und wobei zur Ausbildung eines als Leiterplatte geeigneten Metall-Keramik-Substrats die Metalllage strukturiert wird.

2. Verfahren gemäß Anspruch 1, wobei die Aktivmetallschicht (15) durch ein Gasphasenabscheiden und/oder elektrochemisch oder chemisch auf das Keramikelement (10) und/oder eine Seite der Metalllage, insbesondere eine Innenseite des Behälters (25), aufgetragen wird.

3. Verfahren gemäß einem der vorhergehenden Ansprüche, wobei die Aktivmetallschicht (15) strukturiert aufgetragen wird und/oder strukturiert wird.

4. Verfahren gemäß einem der vorhergehenden Ansprüche, wobei die Aktivmetallschicht (15) vor dem heißisostatischen Pressen einem Energieeintrag ausgesetzt wird.

5. Verfahren gemäß einem der vorhergehenden Ansprüche, wobei die Ausbildung des gasdichten Behälter (25) im Vakuum oder in einer definierten Gasatmosphäre durchgeführt wird, wobei insbesondere ein Innenraum des Behälters (25) vakuumiert und/oder mit Stickstoff geflutet wird.

6. Verfahren gemäß einem der vorhergehenden Ansprüche, wobei ein Verhältnis einer ersten Dicke (D1) der Aktivmetallschicht (15) zu einer zweiten Dicke (D2) einer Metalllage und/oder einer weiteren Metalllage, aus der der Behälter (25) geformt wird, einen Wert annimmt, der kleiner als 0,003 bevorzugt kleiner als 0,0015, besonders bevorzugt kleiner als 0,001 ist.

7. Verfahren gemäß einem der vorhergehenden Ansprüche, wobei beim hei-βisostatischen Pressen der Behälter (25) in einer Heiz- und Druckvorrichtung (40) einem Gasdruck zwischen 100 und 2000 bar, bevorzugt 150 bar und 1200 bar und besonders bevorzugt 300 und 1000 bar, und einer Prozesstemperatur zwischen 300 °C bis zur Schmelztemperatur, insbesondere bis zu einer Temperatur unterhalb der Schmelztemperatur der Metallage, ausgesetzt wird.

8. Verfahren gemäß einem der vorhergehenden Ansprüche, wobei zur Ausbildung eines Metallbehälters (25) eine Metalllage und eine weitere Metalllage vorgesehen sind, die derart dimensioniert sind, dass jeweils ein Abschnitt der Metalllage und der weiteren Metalllage gegenüber einem äußersten Rand des Keramikelements (10) übersteht, wobei die überstehenden Abschnitte zur Ausbildung des Metallbehälters (25) verbunden werden, vorzugsweise nachdem die überstehenden Abschnitte mit einer Spannkraft verformt wurden.

9. Verfahren gemäß einem der vorhergehenden Ansprüche, wobei die Metalllage als separates Bauteil in dem Behälter (25) angeordnet wird.

10. Verfahren gemäß einem der vorhergehenden Ansprüche, wobei ein Anteil an Aktivmetall in der Kontaktschicht größer als 25 Gew.-% und bevorzugt größer als 50 Gew.-%.

11. Verfahren gemäß einem der vorhergehenden Ansprüche, wobei zum Ausbilden des Metall-Keramik-Substrats (1) zwischen der Metalllage und dem Keramikelement (10) mindestens abschnittsweise eine Aktivmetallschicht (15) und eine ein Aktivmetall umfassende Kontaktschicht, zur Unterstützung des Anbindens der Metalllage an das Keramikelement (10), angeordnet wird.

## Claims

1. A method for the production of a metal-ceramic substrate (1) comprising:
- providing a ceramic element (10) and a metal layer,
- providing a gas-tight container (25) enclosing the ceramic element (10), wherein the container (25) is preferably formed from the metal layer or comprises the metal layer,
- forming the metal-ceramic substrate (1) by bonding the metal layer to the ceramic element (10) by means of hot isostatic pressing,
wherein, for forming the metal-ceramic substrate (1), an active metal layer (15) or a contact layer comprising an active metal is arranged at least in sections between the metal layer and the ceramic element (10) to support the bonding of the metal layer to the ceramic element (10), wherein the active metal is titanium, zirconium, hafnium, chromium, niobium, cerium, tantalum, magnesium, lanthanum, vanadium, molybdenum or tungsten, wherein a proportion of active metal in the contact layer is greater than 15 wt. % and wherein the metal layer is structured to form a metal-ceramic substrate suitable as a printed circuit board.

2. The method according to claim 1, wherein the active metal layer (15) is applied to the ceramic element (10) and/or a side of the metal layer, in particular an inner side of the container (25), by vapor deposition and/or electrochemically or chemically.

3. The method according to any one of the preceding claims, wherein the active metal layer (15) is applied in a structured manner and/or is structured.

4. The method according to any one of the preceding claims, wherein the active metal layer (15) is subjected to an energy input prior to the hot isostatic pressing.

5. The method according to one of the preceding claims, wherein the forming of the gas-tight container (25) is carried out in a vacuum or in a defined gas atmosphere, wherein in particular an interior of the container (25) is evacuated and/or flooded with nitrogen.

6. The method according to any one of the preceding claims, wherein a ratio of a first thickness (D1) of the active metal layer (15) to a second thickness (D2) of a metal layer and/or a further metal layer from which the container (25) is formed has a value which is less than 0.003, more preferably less than 0.0015, most preferably less than 0.001.

7. The method according to one of the preceding claims, wherein during hot isostatic pressing the container (25) is subjected to a gaseous pressure of between 100 and 2000 bar, more preferably 150 bar and 1200 bar, and most preferably 300 and 1000 bar, and to a processing temperature of between 300 °C up to the smelting temperature, in particular up to a temperature below the smelting temperature of the metal layer, in a heating and a pressure device (40).

8. The method according to one of the preceding claims, wherein a metal layer and a further metal layer are intended for forming a metal container (25), which are dimensioned in such a way that in each case a section of the metal layer and of the further metal layer projects from an outermost edge of the ceramic element (10), wherein the projecting sections are joined to form the metal container (25), preferably after the projecting sections have been deformed with a clamping force.

9. The method according to any one of the preceding claims, wherein the metal layer is arranged as a separate structural component in the container (25).

10. The method according to any one of the preceding claims, wherein a proportion of active metal in the contact layer is greater than 25 wt. % and more preferably greater than 50 wt. %.

11. The method according to one of the preceding claims, wherein an active metal layer (15) and a contact layer comprising an active metal are arranged at least in sections between the metal layer and the ceramic element (10) to form the metal-ceramic substrate (1), for supporting the bonding of the metal layer to the ceramic element (10).

## Revendications

1. Procédé de fabrication d'un substrat métal-céramique (1), consistant à :
- fournir un élément céramique (10) et une couche métallique,
- fournir un récipient (25) étanche aux gaz qui entoure l'élément céramique (10), le récipient (25) étant de préférence formé à partir de la couche métallique ou comprenant la couche métallique,
- réaliser le substrat métal-céramique (1) par une liaison de la couche métallique à l'élément céramique (10) au moyen d'un pressage isostatique à chaud,
dans lequel, pour réaliser le substrat métal-céramique (1), une couche de métal actif (15) ou une couche de contact comprenant un métal actif est placée au moins localement entre la couche métallique et l'élément céramique (10), afin de favoriser la liaison de la couche métallique à l'élément céramique (10),
dans lequel le métal actif est le titane, le zirconium, le hafnium, le chrome, le niobium, le cérium, le tantale, le magnésium, le lanthane, le vanadium, le molybdène ou le tungstène, une proportion de métal actif dans la couche de contact étant supérieure à 15 % en poids, et la couche métallique étant structurée pour réaliser un substrat métal-céramique convenant comme plaquette à circuits imprimés.

2. Procédé selon la revendication 1,
dans lequel la couche de métal actif (15) est appliquée par dépôt en phase vapeur et/ou par voie électrochimique ou chimique sur l'élément céramique (10) et/ou sur une face de la couche métallique, en particulier sur une face intérieure du récipient (25).

3. Procédé selon l'une des revendications précédentes,
dans lequel la couche de métal actif (15) est appliquée de façon structurée et/ou est structurée.

4. Procédé selon l'une des revendications précédentes,
dans lequel la couche de métal actif (15) est soumise à un apport d'énergie avant le pressage isostatique à chaud.

5. Procédé selon l'une des revendications précédentes,
dans lequel la réalisation du récipient (25) étanche aux gaz se fait sous vide ou dans une atmosphère gazeuse définie, en particulier en mettant sous vide et/ou en inondant d'azote un espace intérieur du récipient (25).

6. Procédé selon l'une des revendications précédentes,
dans lequel un rapport d'une première épaisseur (D1) de la couche de métal actif (15) sur une deuxième épaisseur (D2) d'une couche métallique et/ou d'une autre couche métallique à partir de laquelle le récipient (25) est formé, prend une valeur inférieure à 0,003, de préférence inférieure à 0,0015, de manière particulièrement préférée inférieure à 0,001.

7. Procédé selon l'une des revendications précédentes,
dans lequel, lors du pressage isostatique à chaud, le récipient (25) est soumis, dans un dispositif de chauffage et de pression (40), à une pression de gaz comprise entre 100 et 2000 bars, de préférence entre 150 bars et 1200 bars et de manière particulièrement préférée entre 300 et 1000 bars, et à une température de traitement allant de 300°C jusqu'à la température de fusion, en particulier jusqu'à une température inférieure à la température de fusion de la couche métallique.

8. Procédé selon l'une des revendications précédentes,
dans lequel, pour réaliser un récipient métallique (25), il est prévu une couche métallique et une autre couche métallique qui sont dimensionnées de telle sorte qu'une partie respective de la couche métallique et de l'autre couche métallique fait saillie par rapport à un bord le plus à l'extérieur de l'élément céramique (10), les parties en saillie étant reliées pour réaliser le récipient métallique (25), de préférence après que les parties en saillie ont été déformées avec une force de contrainte.

9. Procédé selon l'une des revendications précédentes,
dans lequel la couche métallique est placée en tant que composant séparé dans le récipient (25).

10. Procédé selon l'une des revendications précédentes,
dans lequel une proportion de métal actif dans la couche de contact est supérieure à 25 % en poids et de préférence supérieure à 50 % en poids.

11. Procédé selon l'une des revendications précédentes,
dans lequel, pour réaliser le substrat métal-céramique (1), une couche de métal actif (15) et une couche de contact comprenant un métal actif est placée au moins localement entre la couche métallique et l'élément céramique (10), afin de favoriser la liaison de la couche métallique à l'élément céramique (10).
